# EUROPEAN PATENT APPLICATION

(11) **EP 3 101 337 A1**
(43) Date of publication of application: **07.12.2016**
(21) Application number: 14880324.0
(22) Date of filing: 23.04.2014
(51) Int. Cl.: F21V 29/00, F21V 3/02, F21V 23/00

(54) **LED LIGHTING APPARATUS**

(30) Priority: 27.01.2014 CN 201410040726
(71) Applicant: Shanghai Sansi Electronic Engineering Co., Ltd, Shanghai 201100 (CN); Shanghai Sansi Science and Technology Development Co., Ltd, Pudong New District, Xincheng Town Nanhui Shanghai 200030 (CN); Jiashan Sansi Photoelectric Technology Co., Ltd, Jiaxing, Zhejiang 314113 (CN)
(72) Inventor: CHEN, Bishou, Shanghai 201100 (CN); XU, Li, Shanghai 201100 (CN); WANG, Peng, Shanghai 201100 (CN); LI, Sheng, Shanghai 201100 (CN)
(74) Representative: Sun, Yiming
(86) International application number: PCT/CN2014/076050
(87) International publication number: WO 2015/109674

(57) **Abstract**

An LED lighting device includes a base (1), an LED light-emitting unit (2) and a lamp shade (3), wherein the LED light-emitting unit (2) and the lamp shade (3) are arranged on the base (1); the lamp shade (3) is a solid component made of a thermally-conductive material; the lamp shade (3) covers the LED light-emitting unit (2); and the inner surface of the lamp shade (3) has a light distribution surface (31) and a thermally-conductive surface (32). The LED lighting device employs a solid material having better thermal conductivity as the lamp shade (3), therefore, heat generated by the LED light-emitting unit not only can be dissipated via the base (1), but also can be transferred outwards via the lamp shade (3), thus allowing the entire device to dissipate heat in all directions, improving the heat dissipation performance of the device, and prolonging the service life of the device; due to the improvement of the heat dissipation performance, the lighting device of higher power can be manufactured without increasing the size of the device, and the lighting brightness of the device is improved, while the use range and flexibility of the LED lighting device are improved in life and industrial use.

## Description

### Field of Invention

The invention relates to an LED, and more particularly to an LED lighting device.

### Description of Related Arts

Application of LED (light-emitting diode) technology triggers a new round of light source revolution, and now, the heat dissipation of LED devices has always been a problem which is more difficult to solve, and therefore the manufacture of high-power LED devices is limited, which results in that the brightness of single LED light source is insufficient and the size of a display-type LED lighting device is too large. A traditional LED light-emitting unit generally comprises a package part, a light-emitting chip, a light source support (also known as a substrate), a circuit board, and a radiator. And a combination of the package part, the light-emitting chip and the light source support is called as the LED device. Since the LED device itself does not have the appropriate electrical and heat dissipation capacity and cannot be used independently, it needs to be coupled to the circuit board for electrical connection, and then the circuit board is adhered to the radiator with thermally-conductive silicone grease and the like to realize heat dissipation. In the traditional LED light-emitting unit, heat generated by the light-emitting chip can be cooled finally only through a path of "a chip-a light source support-an electrical layer on a surface of a circuit board-a circuit board-a thermally-conductive silicone grease-a radiator" in turn, but a huge heat resistance may be generated in this process. Package materials of traditional techniques commonly employ resin materials, which are poor in thermal conductivity, to cause that the heat generated by the chip cannot be transferred outwards in a direction of the package part and can be conducted only in the direction of the radiator. In addition, in the manufacture of a bulb lamp, the chip usually has a separate package component and then is covered by a hollow outer cover to form a shape of the bulb lamp, so that the heat generated by the chip needs to be transferred into air through the separate package component, then is transferred to the outer cover, and finally is transferred to the surrounding air, to cause that the heat is almost impossible to be transferred outwards.

Poor thermal conductivity will prevent the development of the high-power LED devices, if the manufacture of a high-power LED lighting device is required, the size of the device must be increased, to cause a lot of inconvenience in everyday use. Based on the conditions above, the inventors are committed to developing the LED devices with better thermal conductivity.

### SUMMARY OF THE PRESENT INVENTION

For shortcomings in the prior art, an LED lighting device is provided. The LED lighting device has a better heat dissipation function to realize a higher power in a smaller size and to achieve a higher lighting brightness without increasing the size of the device.

An LED (light-emitting diode) lighting device according to the invention, comprises: a base, an LED light-emitting unit and a lamp shade; wherein:
the LED light-emitting unit is arranged on an upper surface of the base; the lamp shade contacts with the base directly, and covers the LED light-emitting unit; the LED light-emitting unit comprises a plurality of LED light-emitting chips;
the lamp shade has an outer surface and an inner surface; the outer surface is a light exit surface; the inner surface comprises a light distribution surface and a thermally-conductive surface, wherein, the light distribution surface is arranged on an inner surface region corresponding to the LED light-emitting chips; a gap is formed between the light distribution surface and the LED light-emitting chips, to form a light distribution chamber together with the upper surface of the base; the thermally-conductive surface is arranged on an inner surface part other than a part where the LED light-emitting chips are installed on the base, or an inner surface region corresponding to the entire upper surface, and closely fits with the base; and the thermally-conductive surface is at least distributed in a central region and an edge region of the inner surface.

Preferably, the inner surface of the lamp shade consists of the light distribution surface and the thermally-conductive surface.

Preferably, the lamp shade is made of transparent ceramic or glass.

Preferably, the transparent ceramic is selected from a group consisting of PLZT (Plomb Lanthanum Zirconate Titanate), CaF₂, Y₂O₃, YAG (Yttrium Aluminum Garnet), polycrystalline AION and MgAl₂O₄.

Through repeated experiments, the inventors manufacture the lamp shade by using PC (Polycarbonate), glass and transparent ceramic respectively. The experimental results show that the junction temperature rise of PC is the maximum; the junction temperature rise of the glass lens is significantly lower than that of PC, and the junction temperature rise of transparent ceramic lens is lower than that of glass. Therefore, the invention adopts the ceramic and glass with better thermal conductivity and lower junction temperature rise in use.

Preferably, the LED light-emitting unit further comprises a circuit board; the LED light-emitting chips are disposed on the circuit board, and the circuit board is disposed on the base.

Preferably, the LED light-emitting unit further comprises a circuit coating; the circuit coating is directly coated on the upper surface of the base; the LED light-emitting chips are directly disposed on the upper surface of the base, and connected with each other through the circuit coating.

Preferably, the circuit coating is a liquid or powder coating containing metal material; a thickness of the circuit coating line layer is 20µm or above.

Preferably, the metal material of the circuit coating is selected from a group consisting of molybdenum, manganese, tungsten, silver, gold, platinum, silver-palladium alloy, copper, aluminum and tin material.

Preferably, the upper surface of the base is flat, curved, or in a shape of multi-planar combination.

Preferably, the outer surface of the lamp shade is made into specific curved shape in accordance with requirements of light distribution; the inner surface in contact with the base is a curved shape corresponding to the upper surface of the base.

Preferably, the base has a first cooling hole.

Preferably, the lamp shade has a second cooling hole, wherein, the second cooling hole is correspondingly communicated with the first cooling hole.

Preferably, the base is a metal base coated with an insulating layer, or a base made of an insulating material.

Preferably, the base has a hollow structure; the first cooling hole on the base is communicated with an outside air through a side of the base.

Preferably, the base has a non-hollow structure; cooling fins are arranged on an outer surface of the base.

Preferably, the device further comprises a power supply chamber, wherein the power supply chamber is not communicated with the base, namely, a cavity of the power supply chamber is isolated from the base. An outer housing of the power supply chamber is connected to the base in inserting, clamping and screwing modes, to realize independent cooling, so as to reduce an influence of heat generated by chips, thereby enhancing an overall thermal capacity of the entire LED lighting device.

Compared with the prior art, the invention has the following beneficial effects:
The material having better thermal conductivity is employed as the lamp shade, as a result, heat generated by the chips not only can be dissipated via the base, but also can be transferred outwards via the thermally-conductive surface which is directly adhered to the base and arranged on the inner surface of the lamp shade. The thermally-conductive surface of the lamp shade is distributed in the central region and the edge region of the inner surface, so compared with the prior art only having the edge contact, a contact area between the lamp shade and the base is increased, thereby improving the heat dissipation function of the lamp shade. Inventors of the invention make calculations by computer thermal-simulation software. According to the invention, compared with existing products having the materials, sizes and powers same as those of the LED lighting device of the invention and only having edge contact, the junction temperature rise is reduced significantly and can be reduced by at least 30°C. Meanwhile, the experimental results obtained by the inventors through repeated experimental verification completely conform to the results simulated by the computer thermal-simulation software. In addition, some preferred structures of the invention, such as the cooling hole and the hollow base, can further enhance the heat dissipation function, thus allowing the entire device to dissipate heat in all directions, greatly improving the heat dissipation performance of the device, and prolonging the service life of the device. An independently arranged power supply chamber allows the heat generated by the chips and a power supply to be dissipated outwards by different structures respectively, thereby reducing the impact on the power supply caused by the heat generated by the chips, and further reducing the impact on the power supply caused by excessive heat.

Further, due to the improvement of the heat dissipation performance, the lighting device of higher power can be manufactured without increasing the size of the device, and the lighting brightness of the device is improved, while the use range and flexibility of the LED lighting device are improved in life and industrial use.

### BRIEF DESCRIPTION OF THE DRAWINGS

Other features, objects, and advantages of the invention will become more apparent from reading the description of non-limiting embodiments detailed with reference to the following figures:
Figure 1 is an overall structure diagram of an LED lighting device according to a first embodiment of the invention;
Figure 2 is a cross-sectional structure diagram of the LED lighting device in Figure 1;
Figure 3 is an overall structure diagram of an LED lighting device according to a second embodiment of the invention;
Figure 4 is a cross-sectional structure diagram of the LED lighting device in Figure 3;
Figure 5 is an overall structure diagram of an LED lighting device according to a third embodiment of the invention;
Figure 6 is a cross-sectional structure diagram of the LED lighting device in Figure 5;
Figure 7 is an assembly diagram of an LED lighting device according to a fourth embodiment of the invention;
Figure 8 is a structure diagram of a light-emitting unit of the LED lighting device according to the fourth embodiment of the invention;
Figure 9 is an overall structure diagram of the LED lighting device according to the fourth embodiment of the invention;
Figure 10 is an overall structure diagram of an LED lighting device according to a fifth embodiment of the invention;
Figure 11 is a cross-sectional structure diagram of the LED lighting device in Figure 10.
Figure 12 is an overall structure diagram of an LED lighting device according to a sixth embodiment of the invention;
Figure 13 is a cross-sectional structure diagram of the LED lighting device in Figure 12;
Figure 14 is a detailed distribution diagram of a light distribution surface 31 and a thermally-conductive surface 32 of a lamp shade 3 as shown in Figure 2;

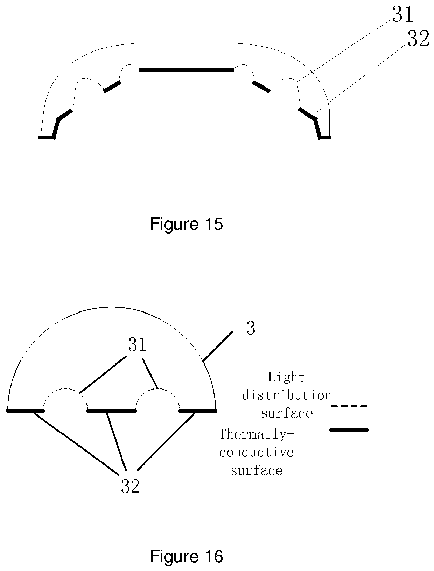

Figure 15 is a detailed distribution diagram of a light distribution surface 31 and a thermally-conductive surface 32 of a lamp shade 3 as shown in Figure 4;
Figure 16 is a detailed distribution diagram of a light distribution surface 31 and a thermally-conductive surface 32 of a lamp shade 3 as shown in Figure 6.

In the drawings:
1 is a base;
2 is an LED light-emitting chip;
3 is a lamp shade;
31 is a light distribution surface;
32 is a thermally-conductive surface;
4 is a circuit board;
5 is a power supply chamber;
6 is a light-emitting module;
7 is a framework;
81 is a first cooling hole;
82 is a second cooling hole;
9 is a cooling fin.

### DETAILED DESCRIPTION OF THE PREFERRED EMBODIMENT

The invention is described in detail as follows with reference to specific embodiments. The following embodiments will help provide further understanding of the invention for those skilled in the art, and not in any way limit the invention. It shall be noted that several variants and improvements can be made without departing from concept of the invention for those of ordinary skill in the art. All these fall within the scope of protection of the invention.

An LED (light-emitting diode) lighting device according to the invention comprises: a base 1, an LED light-emitting unit, a lamp shade 3 and a power supply chamber 5. The lamp shade 3 is made of a thermally-conductive solid material with good heat conduction. The LED light-emitting unit is fixed to the base 1; the lamp shade 3 is disposed on the base 1, to cover the LED light-emitting unit; the lamp shade 3 is in contact with the base 1 by regarding an inner surface other than the corresponding inner surface area (i.e., a light distribution surface 31) of an LED light-emitting chip 2 as a thermally-conductive surface 32, to achieve the heat dissipation function; the inner surface of the corresponding area of the lamp shade 3 and LED light-emitting chip 2 forms a specific shape of space structure according to the design needs, to change the light intensity distribution. The thermally-conductive surface 32 is regarded as a part of the inner surface of the lamp shade 3, and can participate in light distribution by using light reflection and/or refraction. Therefore, technical solutions using the thermally-conductive surface 32 to participate in light distribution also belong to the non-limiting embodiments protected by the invention.

An upper surface of the base 1 is flat, curved, or in a shape of multi-planar combination. The base 1 can employ a hollow structure to increase air circulation and enhance heat dissipation. For example, a first cooling hole 81 is arranged in a middle of the base 1, to increase air circulation and enhance heat dissipation; correspondingly, a second cooling hole 82 is arranged in a corresponding position of the lamp shade 3 and the base 1. An amount of the LED light-emitting chips is more than one.

The lamp shade 3 has a light distribution function, and is made of ceramic, glass or other highly thermally-conductive materials with light transmission performance. The outer surface of the lamp shade 3 is designed into a specific shape according to the actual needs. The base 1 is separately arranged on the power supply chamber 5, to realize independent heat dissipation respectively. The base 1 can be a metal base coated with an insulating layer, a ceramic base, etc.

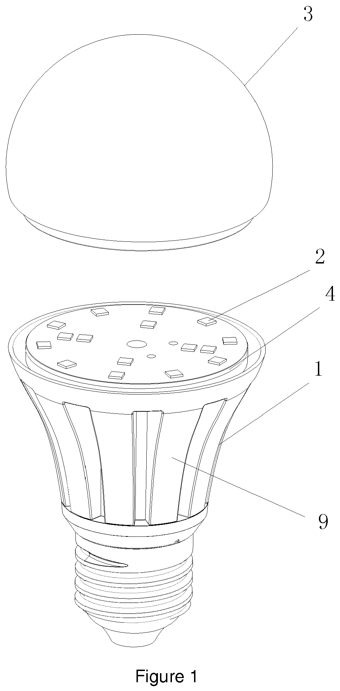

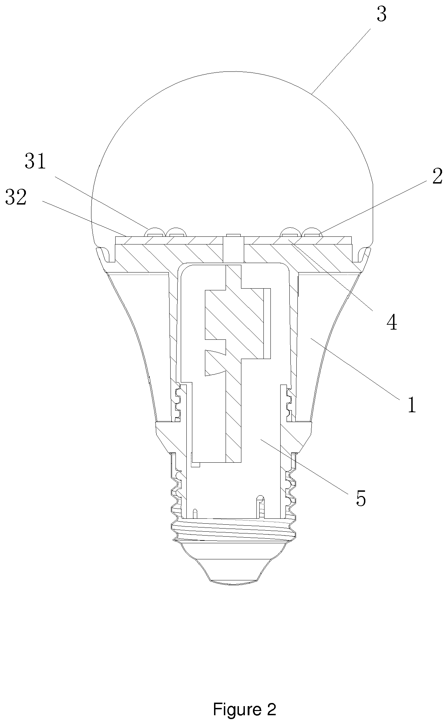

Next, the first embodiment is described in detail with reference to Figure 1 and Figure 2.

The LED lighting device is an LED bulb lamp. The LED bulb lamp mainly comprises a base 1, sixteen LED light-emitting chips 2, a circuit board 4, a lamp shade 3 and a power supply chamber 5. The base 1 is an aluminum base coated with an insulating layer and with a planar upper surface. The circuit board 4 is located on the aluminum base and the sixteen LED light-emitting chips 2 are arranged on the circuit board 4. The lamp shade 3 is a solid transparent glass. The lamp shade 3 contacts with the base 1 directly and covers the base 1 to package the LED light-emitting unit inside. The light distribution surface 31 is arranged on the inner surface corresponding to the LED light-emitting chips 2, but not adhered to the LED light-emitting chips 2, so as to form a light distribution chamber together with the upper surface of the base; the thermally-conductive surface 32 is distributed in a central region and an edge region of the inner surface and completely fits with the upper surface of the base 1, to achieve light transmission and heat dissipation. The base 1 has a non-hollow structure; cooling fins 9 are arranged on an outer surface of the base 1 to increase the cooling area. The power supply chamber 5 and the base are integrally formed; a cavity of the power supply chamber 5 is not communicated with the base 1, to realize independent heat dissipation respectively.

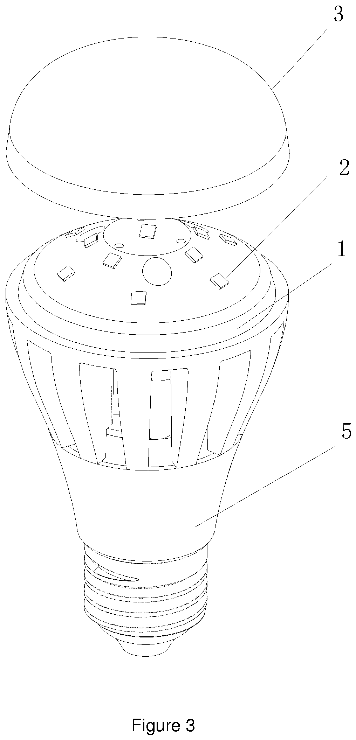

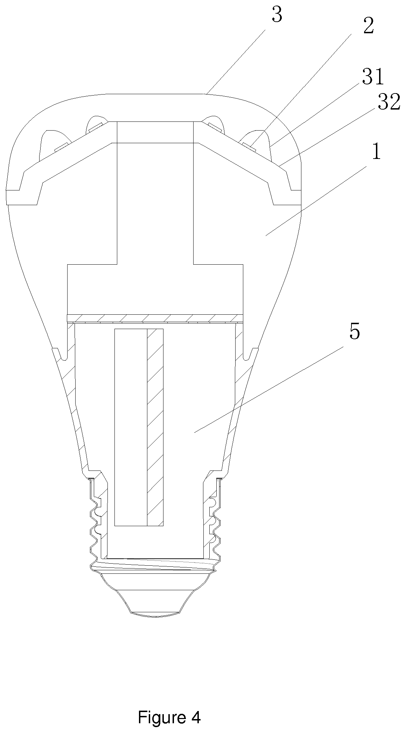

Next, the second embodiment is described in detail with reference to Figure 3 and Figure 4.

The LED lighting device may be an LED bulb lamp. The LED bulb lamp mainly comprises a base 1, twelve LED light-emitting chips 2, a circuit coating, a lamp shade 3 and a power supply chamber 5. The base 1 is a ceramic base 1 with a curved upper surface, and a shape thereof is shown in Figure 3 and Figure 4. The LED light-emitting chips are arranged on a convex curved surface on an upper surface of the base 1. The upper surface of the base 1 is directly coated with the circuit coating to connect all chips with a power supply, to achieve electrical connection. The circuit coating material is a conductive silver paste. The lamp shade 3 is a solid transparent ceramic, which is made of PLZT (Plomb Lanthanum Zirconate Titanate). The lamp shade 3 contacts and engages with the base 1 directly, and covers the base 1 to package the LED light-emitting chips 2 and the circuit coating inside. A light distribution surface 31 is arranged on an inner surface corresponding to the LED light-emitting chips 2, but not adhered to the LED light-emitting chips 2, so as to form a light distribution chamber together with the upper surface of the base; a thermally-conductive surface 32 is distributed in a central region and an edge region of the inner surface and completely fits with the upper surface of the base 1, to achieve light transmission and heat dissipation. The power supply chamber 5 has an independent structure, which is not communicated with the base 1. The base 1 is connected with a housing of the power supply chamber 5 in socket mode, to realize independent heat dissipation respectively.

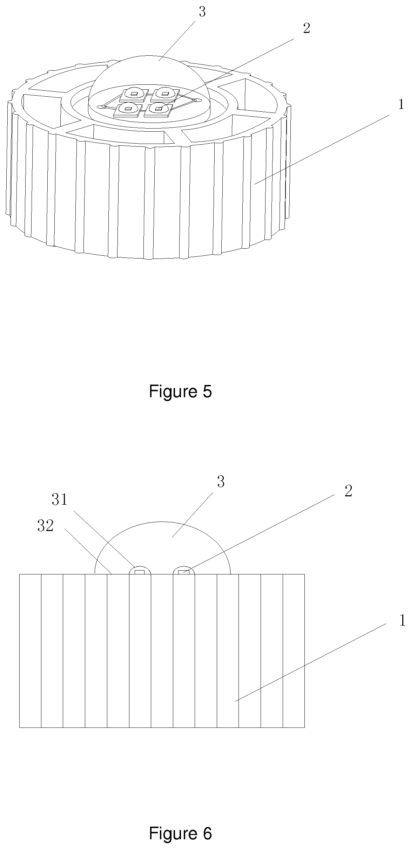

Next, the third embodiment is described in detail with reference to Figure 5 and Figure 6.

The LED lighting device may be a unitized LED lighting device. Each LED lighting device is regarded as an LED light-emitting unit in the entire lighting system, wherein, each LED light-emitting unit mainly comprises a base 1, four LED light-emitting chips 2 and a lamp shade 3. The base 1 is an aluminum base coated with an insulating material; a circuit board 4 is installed on the base 1; and the LED light-emitting chips 2 are arranged on the circuit board 4. The lamp shade 3 is a solid transparent ceramic, which is made of polycrystalline AION. The lamp shade 3 contacts with the base 1 directly and covers the base 1 to package the LED light-emitting chips 2 and the circuit board 4 inside; a light distribution surface 31 is arranged on an inner surface corresponding to the LED light-emitting chips 2, but not adhered to the LED light-emitting chips 2, so as to form a light distribution chamber together with an upper surface of the base; a thermally-conductive surface 32 is distributed in a central region and an edge region of the inner surface and completely fits with the upper surface of the base 1, to achieve light transmission and heat dissipation. The base 1 has a non-hollow structure; cooling fins 9 are arranged on an outer surface of the base 1 to increase the cooling area. A plurality of LED light-emitting units can be combined to form a lighting system.

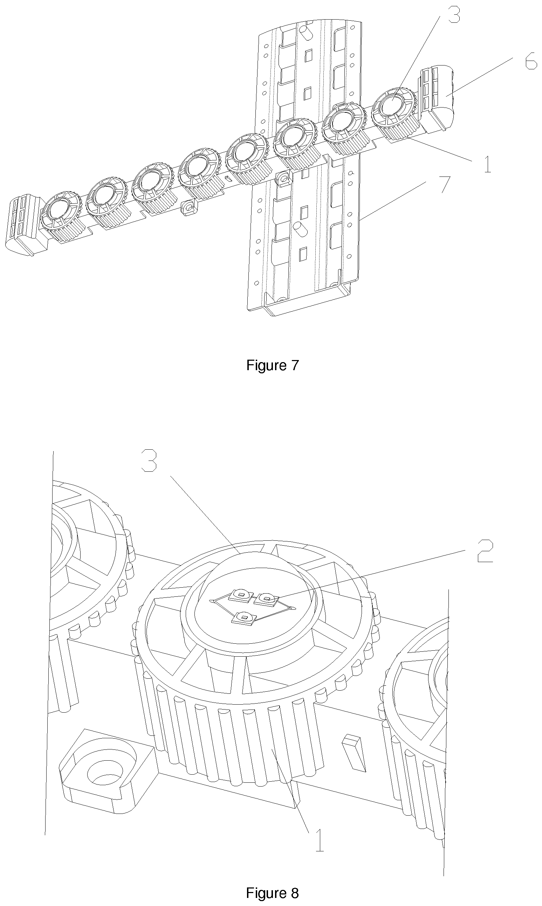

Next, the fourth embodiment is described in detail with reference to Figure 7, Figure 8 and Figure 9.

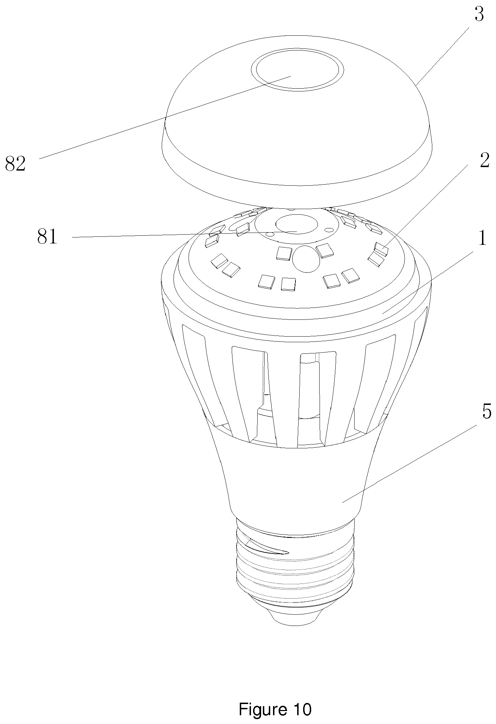

The LED lighting device may be a modular LED lighting device, which mainly comprises a light-emitting module 6 and a framework 7. The modular LED lighting device comprises one base 1, twenty four LED light-emitting chips 2 and eight lamp shades 3. The base 1 is an aluminum base coated with an insulating material; a circuit coating is coated on the insulating material. The twenty four LED light-emitting chips 2, in groups of three, are arranged on the base 1 coated with an insulating material, and connected with each other through the circuit coating. The circuit coating is a conductive copper paste. The eight lamp shades 3 are solid transparent ceramics, which are made of YAG (Yttrium Aluminum Garnet). An outer surface of each lamp shade 3 is hemispherical and covers the base 1. Each lamp shade 3 packages three corresponding LED light-emitting chips 2 inside. A light distribution surface 31 is arranged on an inner surface corresponding to the LED light-emitting chips 2, but not adhered to the LED light-emitting chips 2, so as to form a light distribution chamber together with an upper surface of the base. A thermally-conductive surface 32 is distributed in a central region and an edge region of the inner surface and completely fits with the upper surface of the base 1, to achieve light transmission and heat dissipation. The base 1 has a non-hollow structure and cooling fins 9 are arranged on an outer surface of the base 1 to increase the cooling area. Nine light-emitting modules 6 are connected to the framework 7 to form a complete modular LED lighting system, as shown in Figure 10.

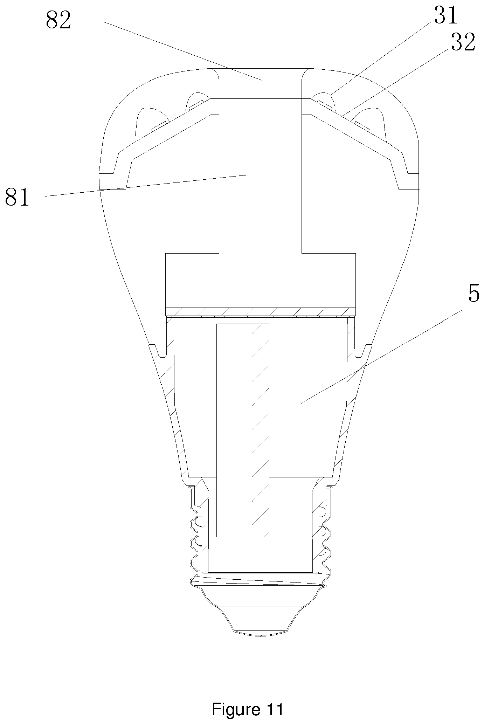

Next, the fifth embodiment is described in detail with reference to Figure 10 and Figure 11.

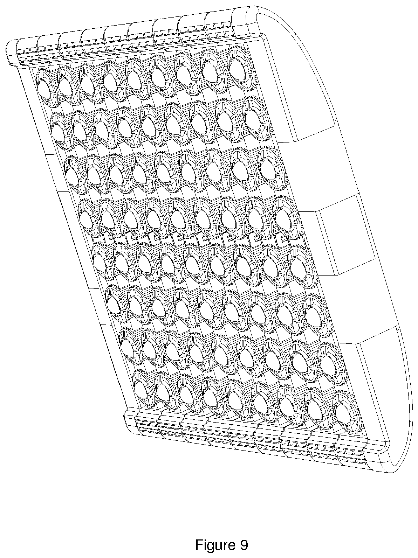

The LED lighting device may be an LED bulb lamp. The LED bulb lamp mainly comprises a base 1, twelve LED light-emitting chips and a highly thermally-conductive lamp shade 3. The base 1 is a ceramic base 1 with a curved upper surface, and a shape thereof is shown in Figure 9 and Figure 10. The base 1 is coated with a circuit coating; the circuit coating is conductive silver-palladium alloy slurry. A first cooling hole 81 is arranged in a middle of the base 1. The LED light-emitting chips 2 are disposed on an upper surface of the base 1 except for cooling holes, and connected with each other through the circuit coating. The lamp shade 3 is a solid transparent ceramic, which is made of MgAl₂O₄. A second cooling hole 82 in a same size is arranged in a middle position corresponding to the first cooling hole 81 of the base 1, to achieve air circulation. An inner surface of the lamp shade 3 in contact with the base 1 is a curved surface corresponding to the shape of the base 1. The lamp shade 3 contacts with the base 1 directly, and covers the base 1 to package the LED light-emitting units 2 and the circuit coating inside. A light distribution surface 31 is arranged on the inner surface corresponding to the LED light-emitting chips 2, but not adhered to the LED light-emitting chips 2, so as to form a light distribution chamber together with the upper surface of the base 1. A thermally-conductive surface 32 is distributed in a central region and an edge region of the inner surface and completely fits with the upper surface of the base 1, to achieve light transmission and heat dissipation. The base 1 has a completely hollow structure to achieve cross ventilation. A housing of the power supply chamber 5 is not communicated with the base 1. The base 1 is connected with the housing of the power supply chamber 5 in screwing mode, to realize independent heat dissipation.

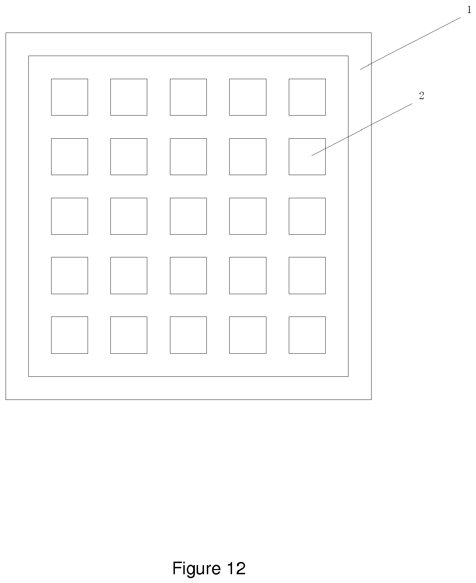

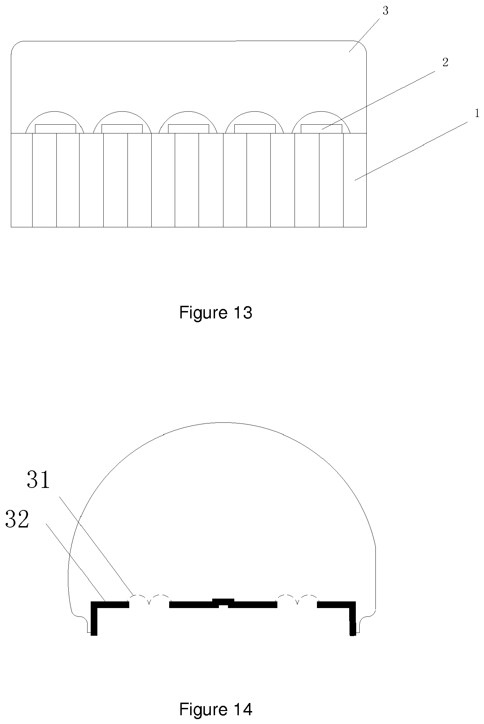

Next, the sixth embodiment is described in detail with reference to Figure 12 and Figure 13.

The LED lighting device comprises a base 1, twenty five LED light-emitting chips and a lamp shade 3. The base 1 is a square ceramic base 1; a circuit board 4 is arranged on the base 1. The LED light-emitting chips 2 are arranged on the circuit board 4. The lamp shade 3 is a solid transparent ceramic. The transparent ceramic is a square corresponding to the base 1 and covers the base 1, to package all LED light-emitting chips 2 and the circuit board 4 inside. A light distribution surface 31 is arranged on an inner surface corresponding to the LED light-emitting chips 2, but not adhered to the LED light-emitting chips 2, so as to form a light distribution chamber together with an upper surface of the base. A thermally-conductive surface 32 is distributed in a central region and an edge region of the inner surface and completely fits with the upper surface of the base 1, to achieve light transmission and heat dissipation.

Specific embodiments of the invention are described above. It shall be understood that the invention is not limited to the above specific embodiments, and those skilled in the art can make different variants and modifications within the scope of the claims, and it shall not affect the substance of the invention.

## Claims

1. An LED (light-emitting diode) lighting device, comprising: a base, an LED light-emitting unit and a lamp shade; wherein:
the LED light-emitting unit is arranged on an upper surface of the base; the lamp shade contacts with the base directly, and covers the LED light-emitting unit; the LED light-emitting unit comprises a plurality of LED light-emitting chips;
the lamp shade has an outer surface and an inner surface; the outer surface is a light exit surface; the inner surface comprises a light distribution surface and a thermally-conductive surface, wherein, the light distribution surface is arranged on an inner surface region corresponding to the LED light-emitting chips; a gap is formed between the light distribution surface and the LED light-emitting chips, to form a light distribution chamber together with the upper surface of the base; the thermally-conductive surface is arranged on an inner surface part other than a part where the LED light-emitting chips are installed on the base, or a region corresponding to the entire upper surface, and closely fits with the base; and the thermally-conductive surface is at least distributed in a central region and an edge region of the inner surface.

2. The LED lighting device according to claim 1, wherein the inner surface of the lamp shade consists of the light distribution surface and the thermally-conductive surface.

3. The LED lighting device according to claim 1, wherein the lamp shade is made of transparent ceramic or glass.

4. The LED lighting device according to claim 3, wherein the transparent ceramic is selected from a group consisting of PLZT (Plomb Lanthanum Zirconate Titanate), CaF₂, Y₂O₃, YAG (Yttrium Aluminum Garnet), polycrystalline AION and MgAl₂O₄.

5. The LED lighting device according to claim 1, wherein the LED light-emitting unit further comprises a circuit board; the LED light-emitting chips are disposed on the circuit board, and the circuit board is disposed on the base.

6. The LED lighting device according to claim 1, wherein the LED light-emitting unit further comprises a circuit coating; the circuit coating is directly coated on the upper surface of the base; the LED light-emitting chips are directly disposed on the upper surface of the base, and connected with each other through the circuit coating.

7. The LED lighting device according to claim 6, wherein the circuit coating is a liquid or powder coating containing metal material; a thickness of the circuit coating is 20µm or above.

8. The LED lighting device according to claim 7, wherein the metal material of the circuit coating is selected from a group consisting of molybdenum, manganese, tungsten, silver, gold, platinum, silver-palladium alloy, copper, aluminum and tin material.

9. The LED lighting device according to claim 1, wherein the upper surface of the base is flat, curved, or in a shape of multi-planar combination.

10. The LED lighting device according to claim 1, wherein the base has a first cooling hole.

11. The LED lighting device according to claim 10, wherein the lamp shade has a second cooling hole, in which the second cooling hole is correspondingly communicated with the first cooling hole.

12. The LED lighting device according to claim 1, wherein the base is a metal base coated with an insulating layer, or a base made of an insulating material.

13. The LED lighting device according to claim 10, wherein the base has a hollow structure; the first cooling hole on the base is communicated with an outside air through a hollow structure of the base.

14. The LED lighting device according to claim 1, wherein the base has a non-hollow structure; cooling fins are arranged on an outer surface of the base.

15. The LED lighting device according to claim 1, further comprising a power supply chamber, wherein an outer housing of the power supply chamber is connected to the base; and a cavity of the power supply chamber is isolated from the base.
